# EUROPÄISCHE PATENTSCHRIFT

(11) **EP 2 724 389 B1**
(45) Veröffentlichungstag und Bekanntmachung des Hinweises auf die Patenterteilung: **16.05.2018**
(21) Anmeldenummer: 12729558.2
(22) Anmeldetag: 20.06.2012
(51) Int. Cl.: H01L 51/05

(54) **ORGANISCHES ELEKTRONISCHES BAUELEMENT**
ORGANIC ELECTRONIC DEVICE
DISPOSITIF ELECTRONIQUE ORGANIQUE

(30) Priorität: 22.06.2011 EP 11170946
(43) Veröffentlichungstag der Anmeldung: 30.04.2014
(73) Patentinhaber: Novaled GmbH, 01307 Dresden (DE); Max-Planck-Gesellschaft zur Förderung der Wissenschaften e.V., 80539 München (DE)
(72) Erfinder: DOROK, Sascha, 01099 Dresden (DE); BLOCHWITZ-NIMOTH, Jan, 01097 Dresden (DE); CANZLER, Tobias, 01099 Dresden (DE); KLAUK, Hagen, 70195 Stuttgart (DE); ANTE, Frederik, 70197 Stuttgart (DE)
(74) Vertreter: Bittner, Thomas L.
(86) Internationale Anmeldenummer: PCT/EP2012/061783
(87) Internationale Veröffentlichungsnummer: WO 2012/175535

(56) Entgegenhaltungen:
- WO-A1-2005/034260
- VANINA V. GUIDI ET AL: "Bis(phosphine Imide)s: Easily Tunable Organic Electron Donors", THE JOURNAL OF ORGANIC CHEMISTRY, Bd. 70, Nr. 19, 1. September 2005 (2005-09-01), Seiten 7737-7743, XP55035338, ISSN: 0022-3263, DOI: 10.1021/jo051196u
- TIWARI S P ET AL: "Pentacene organic field-effect transistors with doped electrode-semiconductor contacts", ORGANIC ELECTRONICS, ELSEVIER, AMSTERDAM, NL, Bd. 11, Nr. 5, 1. Mai 2010 (2010-05-01), Seiten 860-863, XP026999937, ISSN: 1566-1199 [gefunden am 2010-02-04]
- TADA K ET AL: "FIELD-EFFECT MOBILITY OF MOLECULARLY DOPED POLY(3-HEXYLTHIOPHENE)", JPN. J. APPL. PHYS, THE JAPAN SOCIETY OF APPLIED PHYSICS, Bd. 36, Nr. 6A, PART 02, 1. Juni 1997 (1997-06-01), Seiten L718-L720, XP000727780, ISSN: 0021-4922, DOI: 10.1143/JJAP.36.L718
- TSAI E W ET AL: "Electrochemistry of some N-substituted phospha-lambda<5> azenes in acetonitrile", JOURNAL OF ELECTROANALYTICAL CHEMISTRY AND INTERFACIAL ELECTRO CHEMISTRY, ELSEVIER, AMSTERDAM, NL, Bd. 236, Nr. 1-2, 23. Oktober 1987 (1987-10-23), Seiten 219-238, XP026533983, ISSN: 0022-0728, DOI: 10.1016/0022-0728(87)88029-4 [gefunden am 1987-10-23]

## Beschreibung

Die Erfindung betrifft ein organisches elektronisches Bauelement.

### Hintergrund der Erfindung

Organische Halbleiter haben in den letzten Jahren große Aufmerksamkeit erhalten aufgrund ihrer geringen Kosten, der Möglichkeit sie auf großen Flächen und flexiblen Substraten abzuscheiden und der großen Auswahl geeigneter Moleküle. Organische Halbleiter können beispielsweise in schaltbaren Bauelementen wie Transistoren und in Widerständen verwendet werden.

Von den sogenannten planaren Bauelementen ist der organische Transistor das wichtigste Bauelement. Insbesondere organische Dünnfilmtransistoren (OTFT) werden schon seit vielen Jahren untersucht und entwickelt. Es wird erwartet, dass OTFTs im großen Maße beispielsweise in preiswerten integrierten Schaltungen für berührungslose Erkennungsmarken (RFID), aber auch für die Bildschirmansteuerung (Backplane) Anwendung finden. Um preiswerte Anwendungen zu ermöglichen, werden im Allgemeinen zur Herstellung der Transistoren Dünnschichtprozesse benötigt. In den letzten Jahren sind Leistungsmerkmale soweit verbessert worden, dass die Kommerzialisierung von organischen Transistoren absehbar ist. Es wurden zum Beispiel in OTFTs hohe Feldeffektmobilitäten von bis zu 6 cm²/Vs für Elektronen auf Basis von Fulleren-C60 und bis zu 5.5 cm²/Vs für Löcher auf Basis von Pentacene berichtet.

Es wurden OTFTs mit einer Anordnung von zusätzlichen Schichten auf einer aktiven Halbleiterschicht beschrieben. Die zusätzlichen Schichten werden auch als Kapselungs- oder Deckschichten bezeichnet. Zum Beispiel wurden Doppelschichten aus Pentacene und Fulleren C60 verwendet, um ambipolare Bauelement-Funktionalität zu erreichen (Wang et al., Org. Electron. 7, 457 (2006)). In diesem speziellen Fall kann aus den Energieniveaus abgeleitet werden, dass es nicht zu einer technisch relevanten Veränderung der Ladungsträgerdichte in der aktiven Schicht kommt. Auch im Dokument US 2007/034860 A1 wird eine solche Struktur beschrieben.

Das Dokument US 5,500,537 beschreibt eine OTFT-Struktur, bei der auf eine aktive Schicht eine weitere Schicht aufgebracht ist, die ähnlich der Kapselungsschicht ist. Die aktive Schicht ist eine Polymerschicht. Die weitere Schicht steuert die Leitfähigkeit der aktiven Schicht. Die vorgeschlagene Anordnung kann jedoch nur in Geometrien der Schichten funktionieren, bei denen Source / Drain-Kontakte des Bauelements nicht in direktem Kontakt mit der weiteren Schicht angeordnet sind, da sonst hohe Aus-Ströme unvermeidlich sind.

Das Dokument US 2006/0202196 A1 beschreibt Strukturen mit einer Kapselungsschicht, die als eine elektrisch homogen dotierte Schicht ausgeführt ist, wobei ein Matrixmaterial der Kapselungsschicht gleich oder ähnlich einem Material einer aktiven Schicht ist. Das heißt, dass die Mobilität für die aktive Schicht und die Kapselschicht gleich oder zumindest ähnlich sind, und dass die elektrische Leitfähigkeit der Kapselschicht aufgrund der elektrischen Dotierung sogar größer als oder zumindest gleich der elektrischen Leitfähigkeit der aktiven Schicht im Aus-Zustand ist.

Ladungsträgertransport in dünnen organischen Schichten wird im Allgemeinen durch temperaturaktiviertes Ladungsträger-Hopping beschrieben, was zu relativ niedriger Mobilität und einem starken Einfluss von Unordnung führt. Die Feldeffekt-Mobilität in OTFTs hängt im Allgemeinen von der Ladungsträgerdichte ab. Daher ist gewöhnlich eine relativ hohe Gate-Spannung notwendig, um die lokalisierten Zustände zu füllen und eine hohe Ladungsträgermobilität in den organischen Schichten zu erreichen.

Weiterhin muss die erforderliche angelegte Spannung sehr hoch sein, wenn die Ladungsträgerinjektion zwischen einer Elektrode und einem Halbleiter nicht optimal ist. Dies ist jedoch meistens der Fall bei Grenzflächen zwischen einem Metall und einem organischem Material.

B. L. Lucht et al., J. Org. Chem. 2005, 70, 7737-7743 beschreibt die elektrischen Eigenschaften von *p*-Phenylen-bis(triarylphosphinimiden) und die Verwendung dieser Verbindungen in organischen Leuchtioden. Die aromatischen Bis(phosphinimide) zeigen zwei reversible Ein-Elektronenoxidationen bei niedrigen Potentialen und die Oxidationspotentiale dieser organischen Elektronendonoren können leicht durch Substituenten am Phosphor modifiziert werden.

S. P. Tiwari et al., Organic Electronics 2010, 11, 860-863 offenbart einen organischen Dünnfilmtransistor, dessen aktive Schicht im Bereich der Source- und Drainkontakte mit einem Molybdänkomplex dotiert ist.

K. Tada et al., Jpn. J. Appl. Phys. 1979, 36, 718-720 beschreibt die Herstellung und Charakterisierung eines Dünnfilmtransistors, welcher Poly(3-hexylthiophen) dotiert mit dem Elektronentransportmolekül N,N'-Bis(2,5-di-*tert*-butylphenyl)-3,4,9,10-peryleiidiearboxyimid verwendet. Der Dünnfilmtransistor zeigt dipolare Transporteigenschaften.

Das Dokument WO 2005/34260 A1 beschreibt organische Elektrolumineszenzvorrichtungen, enthaltend eine Anode, eine Kathode und wenigstens eine Matrixschicht, enthaltend mindestens ein Matrixmaterial, welches mit einem phosphoreszierenden Emitter dotiert ist, und dadurch gekennzeichnet ist, dass sich die Dotierungszone des Emitters in der Matrix senkrecht zur Schicht nur über einen Teil der Matrixschicht erstreckt.

E. W. Tsai et al., J. Electroanal. Chem. 1987, 236, 219-238 beschreibt die elektrischen Eigenschaften von *N*-Aryl-P,P,P-triphenylphospha-λ⁵-azenen in Acetonitril und den elektronischen Einfluss ihrer Substituenten.

### Zusammenfassung der Erfindung

Aufgabe der Erfindung ist es, ein verbessertes organisches elektronisches Bauelement zu schaffen, das mit geringerer Spannung betrieben werden kann.

Diese Aufgabe wird erfindungsgemäß durch ein Bauelement nach dem unabhängigen Anspruch 1 gelöst. Vorteilhafte Ausgestaltungen der Erfindung sind Gegenstand von abhängigen Unteransprüchen.

Die Erfindung umfasst den Gedanken eines organisches elektronisches Bauelement, mit einer ersten Elektrode, einer zweiten Elektrode, einer Kanalschicht, die ein organisches halbleitendes Material umfasst, und einem Dotandenmaterial nach der Formel A-B (Formel (I)), wobei 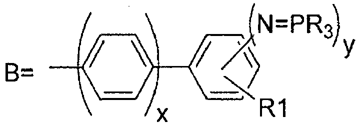 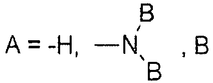 und wobei R1, R, x und y unabhängig für jedes B aus den folgenden Gruppen ausgewählt sind:
- x ist 0, 1 oder 2,
- y ist 1, 2, 3 oder 4,
- R ist aus der Arylgruppe und
- R1 ist aus Alkylgruppe oder der Alkoxygruppe.

Die Komponenten R1 und R sowie die Indizes x und y können für jedes B in dem Dotandenmaterial unabhängig voneinander gewählt werden. Auch für den Fall, dass A gleich B ist, das Dotandenmaterial also die Formel B-B hat, können die beiden B's unterschiedlich beschaffen sein.

Die Kanalschicht umfasst den Kanal, auch Stromkanal oder Leitungskanal genannt (oder *conducting channel*)*.* Die Kanalschicht umfasst ein organisches halbleitendes Material. Das organische halbleitende Material ist ein Ladungstransportmaterial für Ladungsträger, beispielsweise Löcher oder Elektronen. Es kann als Matrixmaterial gebildet sein. Der Begriff Matrixmaterial hat hierbei die Bedeutung, dass das Material den Hauptbestandteil der Schicht bildet. Typischerweise bildet das Matrixmaterial mehr als 50vol% der Schicht, bevorzugt mehr als 90vol%. Bevorzugt ist vorgesehen, dass das organische halbleitende Material ein Elektronen transportierendes Material ist.

Die Elektroden haben eine sehr hohe Leitfähigkeit im Vergleich zu der Kanalschicht. Beispielsweise können die Elektroden aus der folgenden Gruppe von Materialien bestehen: Metall, leitfähige Metalloxide, leitfähige Polymer-basierte Mischungen oder Mischungen hiervon. Bevorzugt sind die beiden Elektroden frei von gegenseitigen Überlappungen. Die beiden Elektroden haben beispielsweise keinen direkten Kontakt miteinander.

In einer Ausgestaltung der Erfindung kann das Bauelement ein Widerstand sein. Hierbei bestimmt die Kanalschicht den Hauptanteil am Widerstandswert des Bauelements.

In einer weiteren Ausgestaltung der Erfindung ist vorgesehen, dass das Bauelement eine Überstromschutzeinrichtung (Sicherung) ist. Hierbei ist das Schaltvermögen der Überstromschutzeinrichtung hauptsächlich durch die Kanalschicht bestimmt, beispielsweise deren Durchbruchspannung, -strom und / oder -temperatur.

In einer weiteren Ausgestaltung der Erfindung kann vorgesehen sein, dass das Bauelement ein Wandler (*Transducer*) ist, beispielsweise ein Dehnungsmessstreifen (*strain gauge*). Hierbei dient die Kanalschicht als Haupt-Halbleiterschicht im Bauelement. Bei einer Änderung der Eigenschaften des organischen halbleitenden Materials in der Kanalschicht durch externe Einflüsse verändert sich die Leitfähigkeit des Bauelements.

In einer weiteren Ausgestaltung der Erfindung kann vorgesehen sein, dass das Bauelement ein Transistor ist, beispielsweise ein organischer Dünnfilmtransistor (OTFT - *organic thin film transistor*) oder ein organischer Feldeffekttransistor (OFET - *organic field effect transistor*). In einer Ausgestaltung kann der Transistor ein Step-Edge OFET sein. Konventionelle Step-Edge Transistoren sind aus dem Stand der Technik bekannt, z.B. aus Fanghua Pu et al. Applied Physics Express 4 (2011) 054203.

Der Transistor kann eine erste Elektrode, eine zweite Elektrode und eine Gate-Elektrode sowie mehrere Schichten umfassen. Die Elektroden und die mehreren Schichten des Transistors können beispielsweise auf einem Substrat gebildet sein, beispielsweise als Dünnschichten. Es kann vorgesehen sein, dass mit dem Substrat selbst bereits eine oder mehrere der Elektroden bereit gestellt sind, beispielsweise mittels eines Silizium-Substrates. Auf oder in dem Substrat können beispielsweise ein Drain- und ein Source-Kontakt oder alternativ die Gate-Elektrode gebildet sein. Es wird ein organischer Feldeffekt-Transistor vom n-Typ bevorzugt.

In einer bevorzugten Ausführungsform ist vorgesehen, dass das Dotandenmaterial in einer Dotierungsmaterialschicht eingelagert ist. Ergänzend oder alternativ kann vorgesehen sein, dass das Dotandenmaterial in dem organischen halbleitenden Material eingelagert ist.

In einer weiteren Weiterbildung der Erfindung kann vorgesehen sein, dass die Dotierungsmaterialschicht aus dem Dotandenmaterial besteht.

Gemäß einer bevorzugten Ausbildung ist vorgesehen, dass die Dotierungsmaterialschicht auf dem organischen halbleitenden Material angeordnet ist.

Eine Weiterbildung der Erfindung sieht vor, dass der Betrag der Differenz zwischen dem Oxidationspotenzial des Dotandenmaterials (OP) und dem Reduktionspotenzial des organischen halbleitenden Materials (RP) größer als etwa 0,5 V ist. Der absolute Wert der Differenz zwischen dem OP und dem RP ist also entweder kleiner als -0,5 V oder größer als 0,5 V.

Es kann nach einer weiteren Fortbildung vorgesehen sein, dass die Dotierungsmaterialschicht mehrschichtig gebildet ist. Die Dotierungsmaterialschicht kann eine erste Teilschicht und eine zweite Teilschicht umfassen, wobei die erste Teilschicht aus dem Dotandenmaterial besteht, die zweite Teilschicht aus einem Ladungsträger transportierenden Matrixmaterial besteht und die zweite Teilschicht zwischen der ersten Teilschicht und der Kanalschicht sowie in Kontakt mit der ersten Teilschicht und der Kanalschicht angeordnet ist.

Nach einer weiteren bevorzugten Ausfuhrungsform ist vorgesehen, dass die Dotierungsmaterialschicht in direktem Kontakt mit der ersten Elektrode und der zweiten Elektrode gebildet ist.

Eine bevorzugte Weiterbildung der Erfindung sieht vor, dass die erste Elektrode als eine Drain-Elektrode konfiguriert ist, die zweite Elektrode als eine Source-Elektrode konfiguriert ist, eine Gate-Elektrode gebildet ist, und eine dielektrische Schicht zwischen der Kanalschicht und der Gate-Elektrode gebildet ist. Die Ausführungsform bezieht sich beispielsweise auf einen Transistor.

Um die Injektion zwischen der ersten und / oder der zweiten Elektrode und der Kanalschicht zu verbessern, kann die Grenzfläche zwischen dem organischen halbleitenden Material und der Elektrode bzw. den Elektroden dotiert werden. Alternativ kann die Grenzfläche mittels einer dünnen Dotandenschicht verbessert werden.

Es wird nach einer Ausführungsform eine Dotierungsmaterialschicht bestimmt, die nicht die Kanalschicht ist, und das Dotandenmaterial nach Formel (I) enthält oder hieraus besteht. Das Dotandenmaterial wirkt hierbei als elektrischer n-Dotand für das organische halbleitende Material in der Kanalschicht. Im Folgenden werden weitere beispielhafte Einsatzmöglichkeiten des Dotandenmaterials nach Formel (I) beschrieben:
Die Dotierungsmaterialschicht kann ausschließlich aus dem Dotandenmaterial nach Formel (I) bestehen. In diesem Fall bildet sie eine reine Injektionsschicht. Die Dotierungsmaterialschicht kann beispielsweise zwischen der Kanalschicht und mindestens einer der Elektroden angeordnet sein. Sie verbessert den Austausch der Ladungsträger zwischen der Kanalschicht und mindestens einer der Elektroden.

Es kann alternativ vorgesehen sein, dass die Dotierungsmaterialschicht ein Matrixmaterial und das Dotandenmaterial nach Formel (I) enthält. Die Dotierungsmaterialschicht bildet in diesem Fall eine dotierte Injektionsschicht. Die Dotierungsmaterialschicht kann beispielsweise wiederum zwischen der Kanalschicht und mindestens einer der Elektroden angeordnet sein. Sie verbessert den Austausch der Ladungsträger zwischen der Kanalschicht und mindestens einer der Elektroden.

Als dotierter Injektionsbereich wird ein Bereich der Kanalschicht bezeichnet, der beispielsweise mit dem Dotandenmaterial dotiert ist und den Austausch der Ladungsträger zwischen der restlichen Kanalschicht und mindestens einer der Elektroden verbessert. Der dotierte Injektionsbereich kann Teil der Kanalschicht sein, er kann aber auch als zusätzliche dotierte Schicht gebildet werden.

Die Erfindung kann beispielsweise mit den Ausführungsformen des Dokuments US 2010/065833 A1 ausgeführt werden. Das organische halbleitende Material der Kanalschicht und das Dotandenmaterial nach Formel (I) bilden eine Kombination von Materialien, bei denen eine elektrische Dotierung des organischen halbleitenden Materials stattfindet, wenn die beiden Materialien in einer Schicht vermischt sind. Die elektrische Dotierung beruht hierbei auf einem teilweisen Ladungstransfer zwischen den beiden Materialien. Bei dem in dieser Ausgestaltung der Erfindung vorgeschlagenen Bauelement befindet sich das organische halbleitende Material in der sogenannten aktiven Schicht und das Dotandenmaterial nach Formel (I) befindet sich außerhalb der Kanalschicht, ist aber beispielsweise in direkten Kontakt hierzu angeordnet

Das Anordnen des Dotandenmaterials nach Formel (I) als eine Deckschicht (Kapselungsschicht) in direktem Kontakt mit der Kanalschicht, hat zur Folge, dass das Fermi-Niveau der Kanalschicht, welche eine aktive Schicht ist, modifiziert wird. Das heißt, Ladungsträger werden in die elektrisch undotierte Kanalschicht induziert, was auch als eine Quasi-Dotierung bezeichnet werden kann. Die induzierten Ladungsträger füllen hierbei bevorzugt tief liegende Niveaus der Zustandsdichteverteilung der aktiven Schicht und stehen nicht oder nur teilweise als freie Ladungsträger in der aktiven Schicht zur Verfügung. Dies hat den Vorteil, dass sich die Feldeffekt-Mobilität mittels Auffüllen von Störstellen erhöht, ohne dass hierdurch zusätzliche Störstellen geschaffen werden. Des Weiteren werden mittels der vorgeschlagenen Ausgestaltung die Einsatzspannung und die Arbeitsspannung des Bauelements verringert, das beispielsweise als organischer Feldeffekt-Transistor ausgestaltet ist.

Eine bevorzugte Weiterbildung der Erfindung sieht vor, dass die Deckschicht aus einem organischen Dotierungsmaterial besteht. Bei einer zweckmäßigen Ausgestaltung der Erfindung kann vorgesehen sein, dass in der Deckschicht das Dotandenmaterial nach Formel (I) in ein Matrixmaterial eingelagert ist, für welches das organische Dotierungsmaterial kein elektrischer Dotand ist.

Die Erfindung kann ergänzend oder alternativ mit den Ausführungsformen des Dokuments US 2010/0051923 A1 ausgeführt werden. Hierbei ist das Dotandenmaterial nicht mit dem organischen halbleitenden Material vermischt, sonder als eine sehr dünne Schicht in einem Grenzflächenbereich zwischen der aktiven Schicht (Kanalschicht) und einer dielektrischen Schicht angeordnet. Alternativ kann das Dotandenmaterial benachbart zu dem Grenzflächenbereich angeordnet sein.

Mithilfe der sehr dünnen Schicht (sogenannte Dotierungsmaterialschicht, die das Dotandenmaterial enthält) erfolgt in den zu der Dotierungsmaterialschicht benachbarten Bereichen der aktiven Schicht eine Quasi-Dotierung in Form einer elektrischen Dotierung, die auf einem teilweisen Ladungstransfer zwischen dem molekularen Dotierungsmaterial einerseits und dem organischen Material der aktiven Schicht andererseits beruht. Störstellen in der aktiven Schicht, die beim Betrieb in dem Leitungskanal dazu führen, dass Ladungsträger, nämlich Elektronen oder Löcher, hierin gefangen werden, was die Beweglichkeit der Ladungsträger innerhalb des Leitungskanals vermindert, werden gesättigt. Die gesättigten Störstellen können den Stromfluss in dem Leitungskanal innerhalb der aktiven Schicht nicht mehr behindern. Ungesättigte Störstellen führen dazu, dass Elektronen oder Löcher eingefangen werden, sodass diese Ladungsträger auf ihrem Weg durch den Leitungskanal zwischen einer Source- und einer Drain-Elektrode mehrfach in Störstellen gefangen und wieder freigelassen werden. Diese nachteilige Wirkung wird mit der Quasi-Dotierung wesentlich gemindert oder sogar ganz ausgeschlossen.

Die Dotierungsmaterialschicht kann als eine nicht geschlossene oder eine geschlossene Schicht gebildet sein. Die geschlossene oder nicht geschlossene Schicht, welche zum Beispiel von mehreren voneinander getrennten Teilbereichen gebildet sein kann, kann auf einen Teilabschnitt des Grenzflächenbereiches beschränkt sein. Die Schichtdicke der Dotierungsmaterialschicht beträgt bevorzugt höchsten ein Zehntel der Schichtdicke der aktiven Schicht. Bevorzugt ist eine Dotierungsmaterialschicht mit einer Dicke von gleich oder weniger als 5 nm.

Die Begriffe "Energie des HOMOs" bzw. E(HOMO) *(HOMO* - *highest occupied molecular orbital*) sowie "Energie des LUMOs" bzw. E(LUMO) *(LUMO* - *lowest unoccupied molecular orbital*) werden üblicherweise synonym mit den Begriffen Ionisationsenergie (oder Ionisierungsenergie) beziehungsweise Elektronenaffinität verwendet (Koopmans Theorem). Bei einer n-Dotierung erfolgt ein Elektronentransfer vom HOMO Niveau des n-Dotanden zum LUMO Niveau des Matrixmaterials, wobei das Elektron nicht stark lokalisiert ist, sondern zu den Ladungsträgern beizählt.

Eine Weiterbildung der Erfindung sieht vor, dass der Betrag einer Differenz zwischen dem HOMO des Dotandenmaterials nach Formel (I) und dem LUMO eines Matrixmaterials der Kanalschicht kleiner als etwa 1 eV ist, weiter bevorzugt ist der Betrag der Differenz kleiner als etwa 0.5 eV.

Das organische halbleitende Material der Kanalschicht kann beispielsweise ein Elektronen transportierendes Material sein. Das Material kann eine hohe intrinsische Ladungsträgerbeweglichkeit aufweisen, beispielsweise größer als 10⁻⁴ cm^{2/}Vs, bevorzugt größer als oder gleich 10⁻¹ cm²/Vs. Bevorzugt hat das organische halbleitende Material ein relativ niedriges LUMO Niveau von etwa 3 bis 4.5 eV.

Beispiele für organische halbleitende Matrixmaterialien, die in der Kanalschicht eingesetzt werden können, sind: Fulleren C60 und C70 und Derivate, wie z.B. PCMB, [6,6]-phenyl C61-butyric acid-methyl-ester; Pentacene und Derivate; Rubrene; Oligothiophenes und Derivate; Phthalocyanine und Metallophthalocyanine und Derivate, hauptsächlich fluorierte Metallophthalocyanine; PTCDI, Perylenetetracarboxylic Diimide und Derivate, Polymere, wie z.B. P3HT.

Die Schichten können beispielsweise mittels Vakuumverdampfung hergestellt werden, beispielsweise mittels VTE (*vacuum thermal evaporation*) oder OVPD (*organic vapour phase deposition*)*.* Des Weiteren können Vakuum-Spray-Verfahren für die Herstellung zum Einsatz kommen. Eine weitere beispielhafte Abscheidungsart umfasst den thermisch oder den optisch induzierten Übertrag des Materials von einem Trägersubstrat auf das eigentliche Substrat, zum Beispiel mittels LITI (*laser induced thermal imaging*). Alternativ oder ergänzend können Druckverfahren wie *Stamping, Embossing, Stamp-transfer* eingesetzt werden. Dotierte Schichten werden im Vakuum typischerweise mittels Mischverdampfung aus zwei unabhängig geregelten Quellen für das Matrixmaterial und den Dotanden hergestellt. Sie können alternativ auch mittels Interdiffusion aus einer Dotandenschicht in eine darunter liegende Matrixmaterialschicht gebildet werden, wobei die beiden Materialien nacheinander im Vakuum aufgedampft werden und wonach die Interdiffusion thermisch oder durch Lösungsmittel ermöglicht wird. Unter Umständen muss der Dotand während des Herstellungsprozesses oder nach der Herstellung in der Schicht durch geeignete physikalische und/oder chemische Maßnahmen aktiviert werden, beispielsweise mittels Lichteinwirkung, Einwirkung von magnetischen und / oder elektrischen Feldern.

Alternative Herstellungsmethoden für dotierte Schichten sind:
- Dotierung einer Matrixschicht durch eine Lösung von Dotanden mit anschließendem Verdampfen des Lösungsmittels, insbesondere durch thermische Behandlung.
- Oberflächendotierung einer Matrixmaterialschicht durch eine oberflächlich aufgebrachte Schicht von Dotanden.
- Herstellung einer Lösung von Matrixmolekülen und Dotanden und anschließende Herstellung einer Schicht aus dieser Lösung mittels konventioneller Methoden wie beispielsweise Verdampfen des Lösungsmittels oder Aufschleudern.

Die Dotierung kann alternativ auch derart erfolgen, dass der Dotand aus einer Precursor-Verbindung heraus verdampft wird, die beim Erhitzen und / oder Bestrahlen das Dotandenmaterial freisetzt. Es versteht sich, dass die Freisetzung des Dotandenmaterials auch in der Matrix erfolgen kann.

### Beschreibung bevorzugter beispielhafter Ausführungsbeispiele

Die Erfindung wird im Folgenden anhand von bevorzugten beispielhaften Ausführungsbeispielen unter Bezugnahme auf Figuren einer Zeichnung näher erläutert. Hierbei zeigen:
- Fig. 1: eine schematische Darstellung des Aufbaus eines planaren Bauelements,
- Fig. 2: eine schematische Darstellung des Aufbaus eines weiteren planaren Bauelements,
- Fig. 3: eine schematische Darstellung des Aufbaus noch eines weiteren planaren Bauelements,
- Fig. 4: eine schematische Darstellung des Aufbaus eines beispielhaften planaren Bauelements,
- Fig. 5: eine schematische Darstellung des Aufbaus eines weiteren beispielhaften planaren Bauelements und
- Fig. 6: eine schematische Darstellung des Aufbaus noch eines weiteren beispielhaften planaren Bauelements.

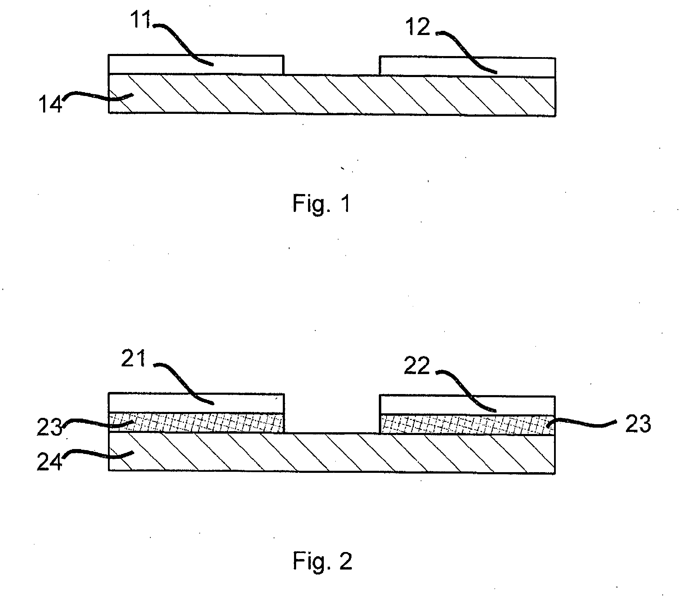

Fig. 1 zeigt eine schematische Darstellung des Aufbaus eines planaren Bauelements mit einer ersten Elektrode 11, einer zweiten Elektrode 12 und einer Kanalschicht 14.

Fig. 2 zeigt eine schematische Darstellung eines weiteren planaren Bauelements mit einer ersten Elektrode 21, einer zweiten Elektrode 22 und einer Kanalschicht 24. Zwischen der ersten und zweiten Elektrode 21, 22 und der Kanalschicht 24 ist jeweils eine Injektionsschicht 23 angeordnet. Die Injektionsschichten 23 können das Dotandenmaterial enthalten.

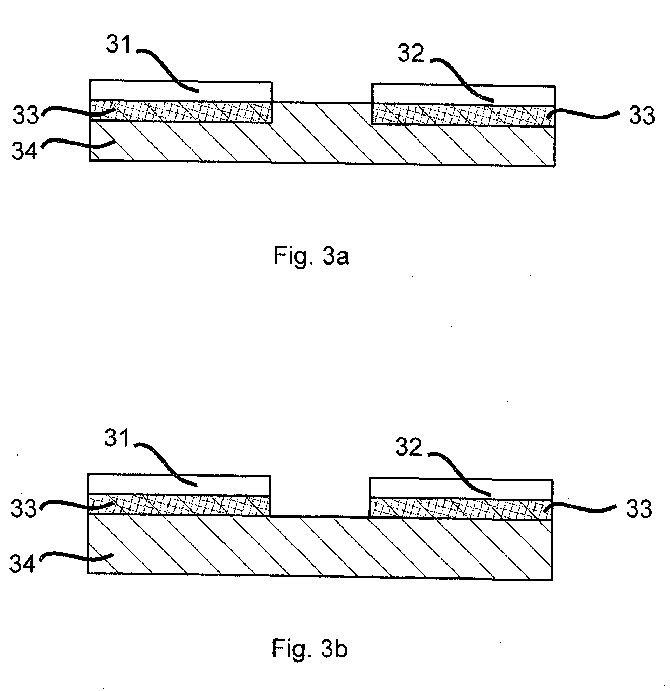

In Fig. 3 ist eine schematische Darstellung des Aufbaus noch eines weiteren planaren Bauelements dargestellt. Das Bauelement umfasst eine erste Elektrode 31, eine zweite Elektrode 32 und eine Kanalschicht 34. An die erste und zweite Elektrode 31, 32 angrenzend sind Injektionsbereiche 33 gebildet. Die Injektionsbereiche 33 können mit dem Dotandenmaterial dotiert sein. In Fig. 3a sind die Injektionsbereiche 33 als Teil der Kanalschicht 34 gebildet. Fig. 3b zeigt eine Ausführungsform, bei der die Injektionsbereiche 33 als eine zusätzliche dotierte Schicht zwischen der Kanalschicht 34 und der ersten und zweiten Elektrode 31, 32 gebildet sind. Die zusätzliche Schicht umfasst ein Halbleitermaterial als Matrixmaterial und das Dotandenmaterial nach Formel (I). Die zusätzliche Schicht und die Kanalschicht können hierbei dasselbe Halbleitermaterial umfassen.

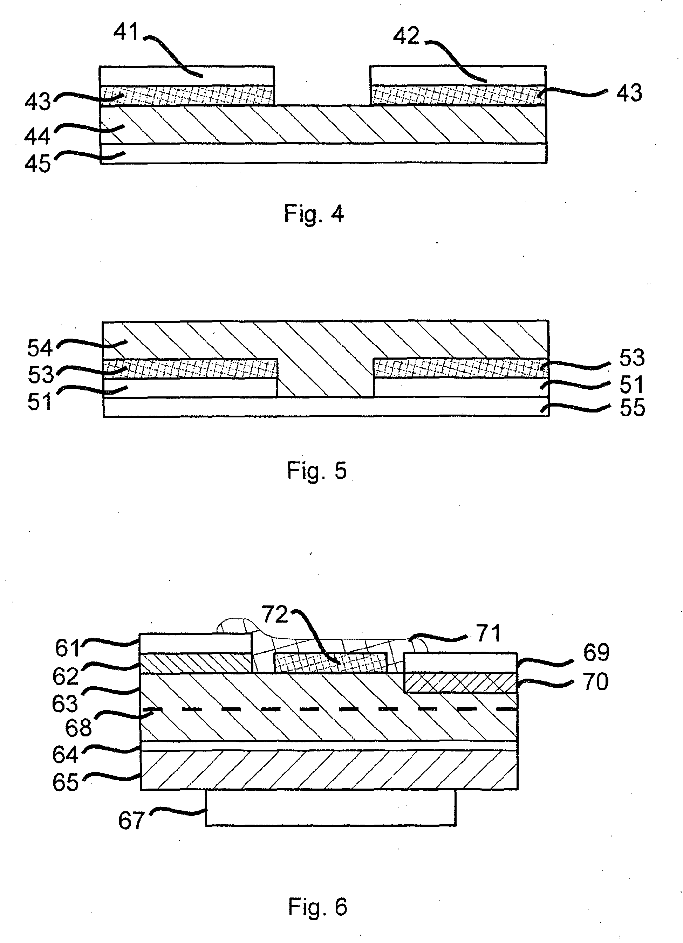

Fig. 4 zeigt eine schematische Darstellung des Aufbaus eines planaren Bauelements mit einer ersten Elektrode 41 und einer zweiten Elektrode 42 sowie einer Kanalschicht 44. An die erste und zweite Elektrode 41, 42 angrenzend sind wiederum dotierte Injektionsbereiche 43 gebildet. Die Kanalschicht 44, die Injektionsbereiche 43 sowie die erste und zweite Elektrode sind auf einem Substrat 45 angeordnet.

Fig. 5 eine alternative schematische Darstellung des Aufbaus eines planaren Bauelements. Das Bauelement umfasst eine erste Elektrode 51, eine zweite Elektrode 52, eine Kanalschicht 54 sowie dotierte Injektionsbereicht 53. Die vorgenannten Komponenten sind auf einem Substrat 55 angeordnet.

Fig. 6 zeigt eine weitere alternative schematische Darstellung des Aufbaus eines planaren Bauelements. Das Bauelement umfasst eine erste Elektrode 61 und eine zweite Elektrode 69 sowie ein Substrat 67. Insbesondere ist in Fig. 6 dargestellt, in welchen Bereichen des Bauelements das Dotandenmaterial eingesetzt werden kann. Das Dotandenmaterial kann beispielsweise in einer Injektionsschicht 62, in einem dotierten Injektionsbereich 70, in einer Deckschicht 72, als eine dünne durchbrüchige Kanalschicht 68, und/oder als eine dünne durchbrüchige Schicht 64 zwischen einem Gate-Isolator 65 und einer Kanalschicht 63 eingesetzt werden. Ergänzend oder alternativ kann das Dotandenmaterial in einer unstrukturierten Injektionsschicht eingesetzt werden, die sich durchgängig zwischen einer Source-Elektrode und einem Halbleiter, über der Kanalschicht, und zwischen einer Drain-Elektrode und dem Halbleiter erstreckt (nicht dargestellte Verlängerung der Schicht 62) und die über der Kanalschicht (zwischen der Source und der Drain Elektrode) durch eine Schicht 72 kompensiert wird. Das Dotandenmaterial kann auch in der Schicht 71 eingesetzt werden, um einen anderen Dotanden zu kompensieren, beispielsweise einen p-Dotanden.

In der folgenden Tabelle werden bevorzugte beispielhafte Verbindungen für das Dotandenmaterial nach Formel (I) offenbart.

| | |
|---|---|
| 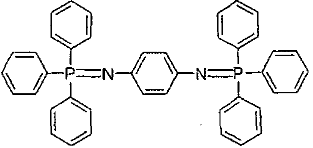 | 1 |
| 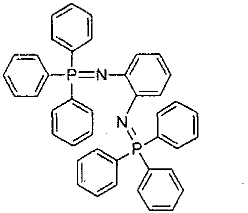 | 2 |
| 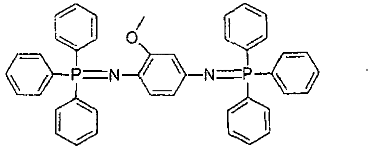 | 3 |
| 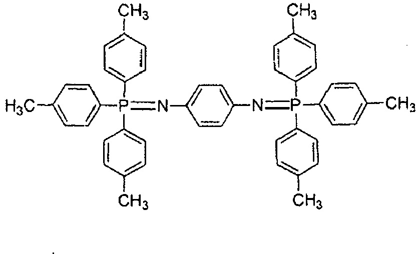 | 4 |
| 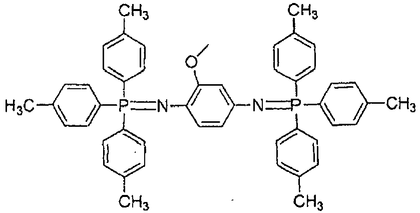 | 5 |
| 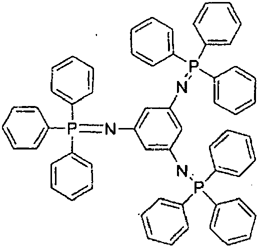 | 6 |
| 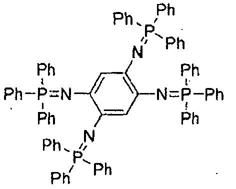 | 7 |
| 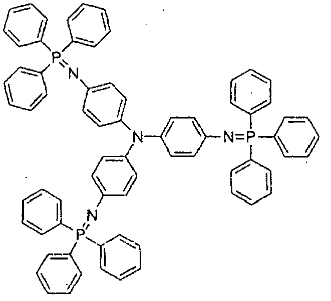 | 8 |
| 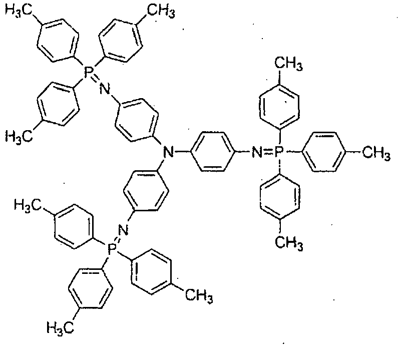 | 9 |
| 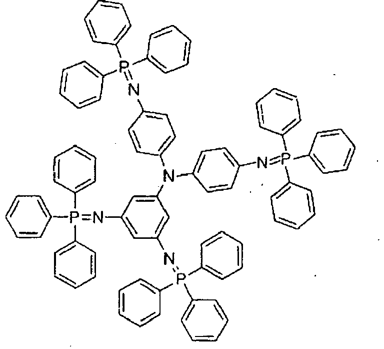 | 10 |
| 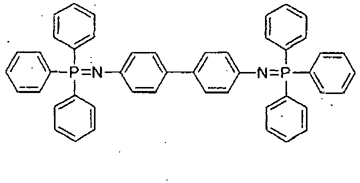 | 11 |
| 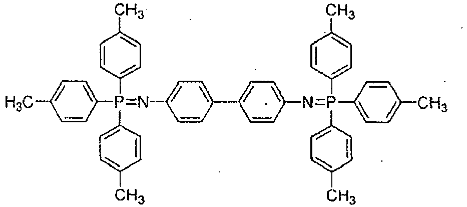 | 12 |
| 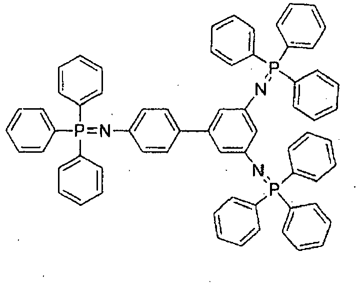 | 13 |
| 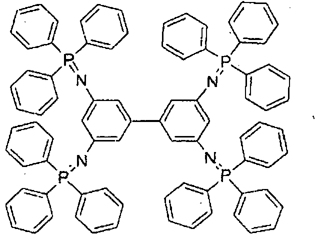 | 14 |
| 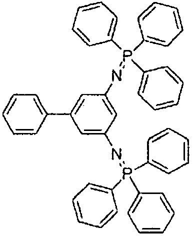 | 15 |
| 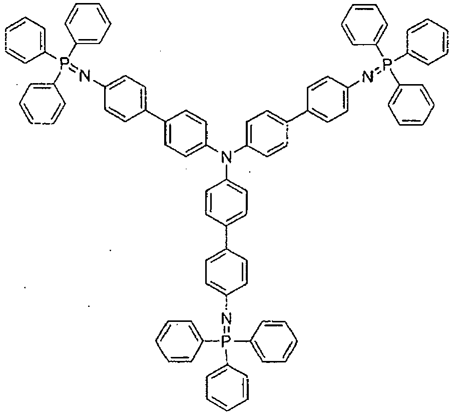 | 16 |
| 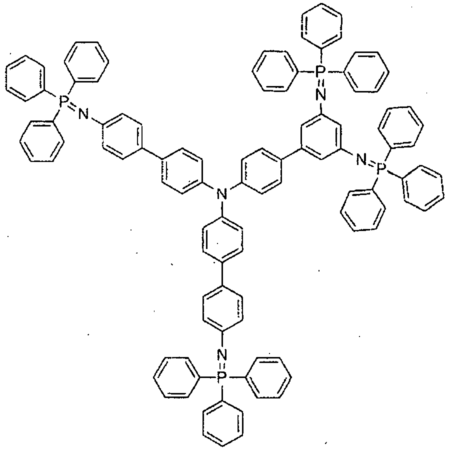 | 17 |
| 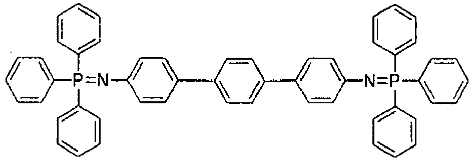 | 18 |
| 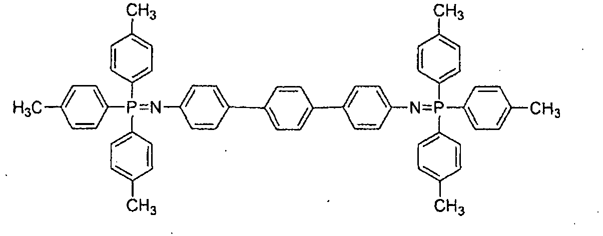 | 19 |
| 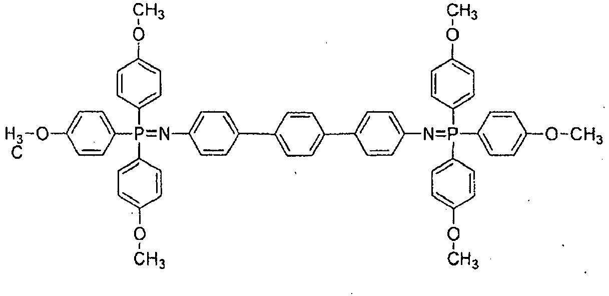 | 20 |
| 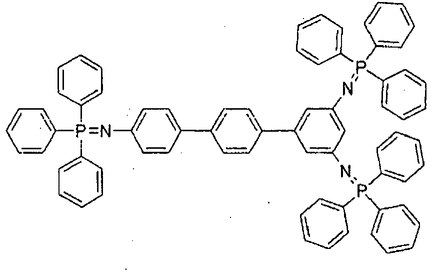 | 21 |
| 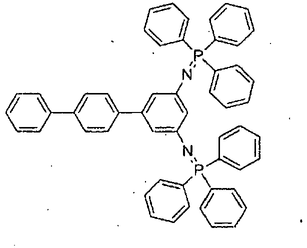 | 22 |
| 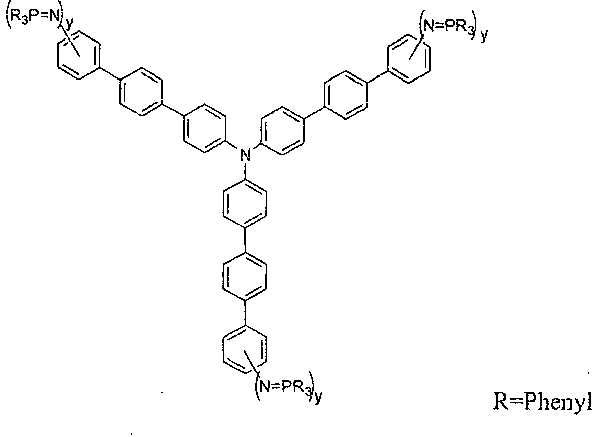 | 23 |
| 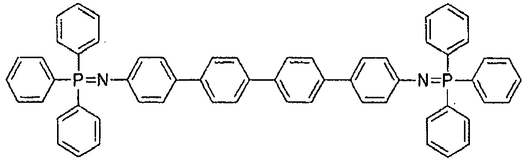 | 24 |
| 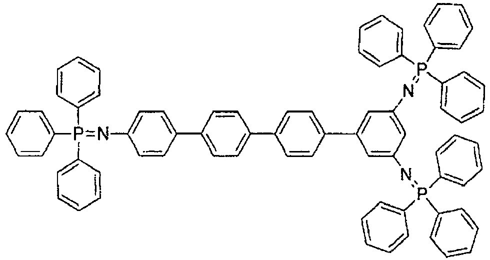 | 25 |

Nachfolgend werden weitere Details zu einigen beispielhaften Verbindungen offenbart.

### Verbindung 1: 1,4-Bis(triphenylphosphinimin)-benzol

12.30 g (37.0 mmol) Triphenylphosphindichlorid wurden in 80 ml Benzol gelöst. 10 ml Triethylamin und 2.0 g (18.5 mmol) 1,4-Phenylendiamin wurden hinzugegeben und die Mischung wurde zwei Tage im Rückfluss erhitzt. Nach Erkalten wurde die Suspension gefiltert und der Niederschlag mit einer verdünnten Natronlauge gefolgt von Ethanol/Wasser gewaschen. Nach dem Trocknen im Vakuum wurden 9.20 g (14.6 mmol; 79%) als gelber Feststoff erhalten. Zur Charakterisierung wurde die Substanz mittels Gradientensublimation gereinigt.
Schmelzpunkt (DSC): 272 °C

### Verbindung 2: 1,2-Bis(triphenylphosphinimin)-benzol

10.0 g (30.0 mmol) Triphenylphosphindichlorid wurden in 100 ml Toluol gelöst. 8.5 ml Triethylamin und 1.62 g (15.0 mmol) 1,2-Phenylendiamin wurden hinzugegeben und die Mischung wurde zwei Tage auf 95 °C erhitzt. Nach dem Erkalten wurde die Suspension gefiltert und der Niederschlag mit Toluol gewaschen. Der Rückstand wurde in einer 2 molaren Natronlauge suspendiert und für 5 Minuten bei 45 °C gerührt. Nach Filtrierung und Trocknen im Vakuum wurden 4.73 g (7.53 mmol; 50%) hell-gelber Feststoff erhalten. Zur Charakterisierung wurde die Substanz mittels Gradientensublimation gereinigt.
Schmelzpunkt (DSC): 257 °C
CV (DCM): 0.29 V vs. Fc

### Verbindung 3: 1,4-Bis(triphenylphosphinimin)-2-methoxybenzol

### 1. Schritt: Reduktion von 2-Methoxy-4-nitroanilin

3.0 g (17.8 mmol) 2-Methoxy-4-nitroanilin und 0.8 g Palladium auf Aktivkohle (10%) wurden zu 100 ml Tetrahydrofuran gegeben. Zu 40 ml Tetrahydrofuran wurden vorsichtig 8.7 ml (114.0 mmol) Hydrazin-Monohydrat hinzugegeben und die Reaktion wurde für 3 Stunden bei 90 °C gerührt. Nach dem Erkalten wurde die Suspension filtriert und der Niederschlag mit Tetrahydrofuran gewaschen. Die Mutterlauge wurde unter reduziertem Druck zu einem grauen Rückstand eingeengt. 2.44 g (17.7 mmol, 99%) des Produkts wurden unter Argon gelagert und ohne weitere Reinigung verwendet.

### 2. Schritt: 1,4-Bis(triphenylphosphinimin)-2-methoxybenzol

3.71 g (11.2 mmol) Triphenylphosphindichlorid wurde unter Argon in 50 ml Toluol gelöst. Eine Suspension von 3.1 ml (22.3 mmol) Triethylamin und 0.77 g (5.6 mmol) 2-Methoxy-1,4-phenylendiamin in 50 ml Toluol wurden hinzugefügt und die Mischung wurde zwei Tage auf 95 °C erhitzt. Nach dem Erkalten wurde die Suspension gefiltert und der Niederschlag mit Toluol gewaschen und danach in einer 2 molaren Natronlauge suspendiert und für 5 Minuten bei 45 °C gerührt, filtriert und mit Wasser gewaschen. Nach dem Trocknen im Vakuum wurden 1.96 g (2.98 mmol; 53%) brauner Feststoff erhalten.
Schmelzpunkt (DSC): 206 °C
CV (DCM): -0.45 V vs. Fc (rev)

### Verbindung 4: 1,4-Bis(tritolylphosphinimin)benzol

### 1. Schritt: Herstellung von Tris(4-methylphenyl)phosphindichlorid

11.7 g (49.3 mmol) Hexachlorethan wurde unter Argon zu einer Suspension von 15.0 g (49.3 mmol) Tris(4-methylphenyl)phosphin in 80 ml Acetonitril gegeben. Die Mischung wurde bei 95 °C für 17 Stunden gerührt. Nach Abkühlung wurden 200 ml trockenes Toluol hinzugegeben und 50 ml Acetonitril wurden unter reduziertem Druck entfernt. Der Niederschlag wurde filtriert und mit 50 ml trockenem Toluol und 50 ml trockenem Hexan gewaschen. 9.83 g (53%) weißer Feststoff wurden nach dem Trocknen im Vakuum erhalten.

### 2. Schritt: 1,4-Bis(tritoluylphosphinimin)-benzol

Eine Lösung von 5.8 ml (41.6 mmol) Triethylamin in 10 ml trockenem Toluol wurde unter Argonatmosphäre bei 5 °C zu einer Mischung aus 7.81 g (20.8 mmol) Tris(4-methylphenyl)-phosphindichlorid gegeben. 1.12 g (10.4 mmol) 1,4-Phenylendiamin wurden hinzugefügt. Die Mischung wurde bei 110 °C für 1 Stunde gerührt. Der gelbe Niederschlag wurde abfiltriert und mit Toluol und Hexan gewaschen. Das trockene Rohprodukt wurde in 2 molarer Natronlauge suspendiert und für 5 Minuten bei 45 °C gerührt. Nach Filtrieren, Waschen mit Wasser und Trocknen im Vakuum wurden 5.43 g (7.6 mmol; 73.3 %) heil-gelber Feststoff erhalten. Zur Charakterisierung wurde die Substanz mittels Gradientensublimation gereinigt.
Schmelzpunkt (DSC): 267 °C
CV (DCM): -0.46 V vs. Fc (rev)

### Verbindung 5: 1,4-Bis(tritoluylphosphinimin)-2-methoxybenzol

### 1. Schritt: Herstellung von Tritoluylphosphindichlorid

Siehe oben

### 2. Schritt: Reduzierung von 2-Methoxy-4-nitroanilin

Siehe oben

### 3. Schritt: 1,4-Bis(tritoluylphosphinimin)-2-methoxybenzol

2.0 g (5.33 mmol) Tritoluylphosphindichlorid wurde unter Argon in 10 ml Toluol gelöst. Eine Suspension von 1.5 ml (10.7 mmol) Triethylamin und 0.37 g (2.7 mmol) 2-Methoxy-1,4-phenylendiamin in 15 ml Toluol wurde hinzugegeben und die Mischung wurde für 18 Stunden auf 90 °C erhitzt. Nach dem Abkühlung wurde die Suspension gefiltert und der Niederschlag mit Toluol gewaschen und danach in einer 2 molaren Natronlauge suspendiert und für 5 Minuten bei 45 °C gerührt, gefiltert und mit Wasser gewaschen. Nach dem Trocknen im Vakuum wurden 0.43 g (0.59 mmol; 22%) gelber Feststoff erhalten.
Schmelzpunkt (DSC): 239 °C
CV (DCM): -0.51 V vs. Fc

### Verbindung 7: 1,2,4,5-Tetra(triphenylphosphinimin)benzol

4.9 ml (35.2 mmol) Triethylamin und 0.5 g (1.78 mmol) 1,2,4,5-Tetraaminobenzol Tetrahydrochlorid wurden in 20 ml Acetonitril suspendiert. 2.93 g (8.8 mmol) Triphenylphosphindichlorid wurde in 15 ml Acetonitril gelöst und bei 0 °C zu der Suspension hinzugegeben. Die Mischung wurde bei Raumtemperatur für 18 Stunden gerührt. Die Suspension wurde filtriert und der Niederschlag wurde in 2 molarer Natronlauge suspendiert und für 5 Minuten bei 45 °C gerührt. Nach Filtrierung und Trocknen im Vakuum wurden 0.74 g (0.6 mmol; 35%) rot-brauner Feststoff erhalten.
Schmelzpunkt (DSC): 283 °C
CV (DCM) = -1.02 V vs. Fc (rev.)

### Verbindung 8: Tris(4-triphenylphospiniminphenyl)amin

1.72 g (5.44 mmol) Triphenylphosphindichiorid wurden unter Argonatmosphäre in 8 ml Dichlormethan gelöst. 1.8 ml (12.9 mmol) Triethylamin in 2 ml Dichloromethan wurde langsam zu der-Lösung hinzugegeben. 0.5 g (1.7 mmol) Tris(4-aminophenyl)amin wurde hinzugefügt und die Mischung wurde bei Raumtemperatur für 4 Tage gerührt. Die Reaktion wurde mit Dichlormethan verdünnt und mit Wasser extrahiert. Unter reduziertem Druck wurde die organische Phase eingeengt. Der Niederschlag wurde in einer 2 molaren Natronlauge suspendiert und für 5 Minuten bei 45 °C gerührt. Noch Filtration und Trocknen im Vakuum wurden 1.50 g (1.40 mmol; 82%) Feststoff erhalten.
Schmelzpunkt (DSC): 277 °C
CV (DMF): -0.39 V vs. Fc.

### Verbindung 9: Tris(4-tristoluylphospiniminphenyl)amin

### 1. Schritt: Herstellung von Tritoluylphosphindichlorid

Siehe oben

### 2. Schritt: Tris(4-tristoluylphospiniminphenyl)amin

Eine Lösung von 3.8 ml (27.4 mmol) Triethylamin in 10 ml trockenem Toluol wurde bei 5 °C unter Argonatmosphäre zu einer Mischung von 3.82 g (10.2 mmol) Tris(4-methylphenyl)phosphindichlorid in 40 ml Toluol gegeben. 1.0 g (3.4 mmol) Tris(4-aminophenyl)amin wurde hinzugegeben. Die Mischung wurde bei 110 °C für 1 Stunde gerührt. Der Niederschlag wurde filtriert und mit Toluol und Hexan gewaschen. Das trockene Rohprodukt wurde in 2 molarer Natronlauge suspendiert und für 5 Minuten bei 45 °C gerührt. Nach Filtrierung und Trocknen im Vakuum wurden 3.06 g (2.6 mmol; 75%) leicht-gelber Feststoff erhalten.

### Verbindung 11: 4,4'-Bis(triphenylphosphinimin)-1,1'-biphenyl

4.15 g (12.5 mmol) Triphenylphosphindichlorid wurden in 30 ml Benzol gelöst. 3.4 ml Triethylamin und 1.15 g (6.25 mmol) Benzidin wurden hinzugefügt. Die Mischung wurde für 3 Stunden unter Rückfluss gerührt. Nach Erkalten wurde die Suspension filtriert und der gelbe Niederschlag mit verdünnter Natronlauge gefolgt von Ethanol/Wasser gewaschen. Nach dem Trocknen im Vakuum wurden 3.20 g (4.66 mmol; 73%) gelber Feststoff erhalten. Zur Charakterisierung wurde die Substanz mittels Gradientensublimation gereinigt.
Schmelzpunkt (DSC): 283 °C
CV (DCM): 0.0 V vs. Fc (rev.)

### Verbindung 18: 4,4"-Bis(triplieiiylpliosphinimin)-p-terphenyl

2.50 g (7.5 mmol) Triphenylphosphindichlorid wurden in 50 ml Toluol gelöst. 2.9 ml Triethylamine und 0.88 g (3.4 mmol) 4,4"-Diamino-*p*-terphenyl wurden hinzugefügt und die Mischung wurde bei 95 °C für 2 Tage gerührt. Nach Abkühlung wurde die Suspension filtriert und der gelbe Niederschlag mit verdünnter Natriumhydroxidlösung gefolgt von Wasser und Acetonitril gewaschen. Nach Trocknen im Vakuum wurden 2.06 g (2.6 mmol; 78%) leicht-gelber Feststoff erhalten. Zur Charakterisierung wurde die Substanz mittels Gradientensublimation gereinigt.
Schmelzpunkt (DSC): 322 °C
CV (DCM): 0.22 V vs. Fc (rev)

### Verbindung 19: N4,N4"-Bis(tri-p-tolylphosphoranyliden)-[1,1':4',1"-terphenyl]-4,4"-diamin

### 1. Schritt: Herstellung von Tritolylphosphindichlorid

11.7 g ((49.3 mmol) Hexachlorethan wurde zu einer Suspension von 15.0 g (49.3 mmol) Tris(4-methylphenyl)phosphin in 80 ml Acetonitril unter Argonatmosphäre gegeben. Die Mischung wurde für 17 Stunden bei 95 °C gerührt. Nach dem Abkühlen wurden 200 ml trockenes Toluol zugegeben und 50 ml Acetonnitril wurden unter reduziertem Druck entfernt. Der Niederschlag wurde filtriert und mit 50 ml trockenem Toluol und 50 ml trockenem Hexan gewaschen. 9.83 g (53%) einer weißen festen Substanz wurden nach dem Trocknen in Hochvakuum erhalten.

### 2. Schritt: Herstellung von N4,N4"-Bis(tri-p-tolylphosphoranyliden)-[1,1':4',1"-terphenyl]-4,4"-diamin

1.69 g (4.5 mmol) in 3.3 ml Dichlormethan wurde zu einer Lösung von 0.52 g (2 mmol) Tritolylphosphindichlorid in 5 ml Toluol gegeben. Nach Hinzufügen von 1 g (10 mmol) Triethylamin wurde die Mischung für drei Stunden unter Rückfluss gerührt. Der Niederschlag wurde filtriert, getrocknet und suspendiert in 2 molarer Natriumhydroxidlösung und für 5 Minuten bei 45 °C gerührt. 0.93 g (1.1 mmol; 55 %) einer braunen festen Substanz wurden nach dem Filtrieren, Waschen mit Wasser und Trocknen im Vakuum erhalten. Zur Charakterisierung wurde die Substanz mittels Gradientensublimation gereinigt.
Schmelzpunkt: 314 °C
CV (DCM): 0.18 V vs. Fc

### Verbindung 20: N4,N4"-Bis(tris(4-methoxyphenyl)phosphoranyliden)-[1,1':4',1"-terphenyl]-4,4"-diamin

### 1. Schritt: Herstellung von 4,4"-Diazid-1,1':4',1"-terphenyl

0.63 g (9.3 mmol) Natriumnitrit in 5 ml Wasser und 0.56 g (9.3 mmol) Urea in 5 ml Wasser wurden zu einer Mischung von 1.2 g (4.5 mmol) [1,1':4',1"-Terphenyl]-4,4"-diamin, 7.5 ml Kieselsäure and 3.3 ml Schwefelsäure bei 0 °C hinzugefügt. Nach 1 Stunde Rühren wurde 0.64 g (9.8 mmol) Natriumazid in 5 ml Wasser langsam hinzugegeben. Die Mischung wurde für 3 Stunden bei Raumtemperatur gerührt und auf Eis gegossen. Der Niederschlag wurde filtriert, mit Wasser gewaschen und im Vakuum getrocknet. Es wurden 1.3 g (4.2 mmol, 93%) brauner Feststoff erhalten, der ohne weitere Reinigung verwendet wurde.

### 2. Schritt: N4,N4"-Bis(tris(4-methoxyphenyl)phosphoranyliden)-[1,1':4',1"-terphenyl]-4,4"-diamin

Zu einer Lösung von 0.66 g (2.1 mmol) 4,4"-Diazid-1,1':4',1"-terphenyl in 15ml Toloul wurde 1.48 g (4.2 mmol) Tris(4-methoxyphenyl)phosphin in 5 ml Toloul unter Argonatmosphäre gegeben. Nach 18 Stunden Rühren bei Raumtemperatur wurde wurde das Lösungsmittel destilliert und der Rückstand mit Toloul gewaschen. 1.70g (1.8 mmol) gelbes Pulver wurde nach dem Trocknen im Vakuum erhalten.
Schmelzpunkt: 328 °C

### Verbindung 28: Nl,N4-Bis(tricyclohexylphosphoranyliden)benzol-1,4-diamin

8.1 g ((34.2 mmol) Hexachlorethan wurden zu einer Suspension von 9.6 g (34.2 mmol) Tricyclohexylphosphin in 60 ml Azetonnitril unter Argonatmosphäre hinzugefügt. Die Mischung wurde für 16 Stunden bei 95°C gerührt. Nach dem Abkühlen auf Raumremperatur wurde eine Lösung von 1.7 g (15.5 mmol) Para-phenylendiamin und 11.5 ml (77.5 mmol) 2,3,4,6,7,8,9,10-Octahydropyrimidon[1,2-a]azepine in 25 ml Azetonnitril hinzu gegeben. Die Mischung wurde für 16 Stunden bei 95°C gerührt und anschließend wieder auf Raumtemperatur abgekühlt. Der Nieerschlag wurde filtriert, getrocknet und in 2 molarer Natriumhydroxidlösung suspendiert und für 5 Minuten bei 45°C gerührt. 5 g (7.5 mmol; 49 %) einer brauen festen Substanz wurden nach dem Filtrieren, Waschen mit Wasser und Trocknen in Vakuum erhalten. Zur Charakterisierung wurde die Substanz mittels Gradientensublimation gereinigt.
Schmelzpunkt: 277°C
CV (THF): -0.07 V vs. Fc

### Verbindung 29: N1,N4-Bis(dimethylaminophosplioranyliden)benzol-1,4-diamin

8.1 g ((34.2 mmol) Hexachlorethan wurden zu einer Suspension von 9.6 g (34.2 mmol) Tricyclohexylphosphin in 75 ml Azetonnitril unter Argonatmosphäre hinzugegeben. Die Mischung wurde für 16 Stunden bei 95°C gerührt. Nach dem Abkühlen auf Raumtemperatur wurde eine Lösung von 3 g (27.7 mmol) Para-phenylendiamin und 20.6 ml (138.5 mmol) 2,3,4,6,7,8,9,10-Octahydropyrimidon[1,2-a]azepin in 15 ml Azetonnitril hinzugefügt. Die Mischung wurde für 16 Stunden bei 95 °C gerührt und anschließend auf Raumtemperatur abgekühlt. Das Lösungsmittel wurde destilliert bis zu 20 ml. Der Niederschlag wurde filtriert, getrocknet und in 2 molarer Natriumhydroxidlösung suspendiert und für 5 Minuten bei 45 °C gerührt. Eine Auswaschung mit Toloul und Waschen mit Ethylacetat sowie Trocknen in Vakuum ergaben 1.2 g (2.8 mmol; 10 %) einer brauen festen Substanz. Zur Charakterisierung wurde die Substanz mittels Gradientensublimation gereinigt.
Schmelzpunkt: 127°C
CV (DCM): -0.61 V vs. Fc

### Verbindung 30: N1,N5-Bis(triphenylphosphoranyliden)naphthalen-1,5-diamin

4.17 g (12.5 mmol) Triphenylphosphindichlorid wurde in 30 ml Benzol gelöst. 3.4 ml Triethylamin and 1.0 g (6.25 mmol) Naphthalen-1,5-diamin wurden hinzugefügt und die Mischung wurde für 3 Tage auf 80°C erhitzt. Nach dem Kühlen wurde die Suspension filtriert, der Rückstand wurde in 2 molarer Natriumhydroxidlösung suspendiert und für 5 Minuten bei 45°C gerührt. 2.18 g (3.21 mmol; 51%) einer gelben festen Substanz wurden nach dem Filtrieren und Trocken im Vakuum erhalten. Zur Charakterisierung wurde die Substanz mittels Gradientensublimation gereinigt.
Schmelzpunkt: 257°C
CV (DCM): 0.26 V vs. Fc

### Verbindung 31: N1,N4-Bis(methyldiphenylphosphoranyliden)benzol-1,4-diamin

4.7 g ((20 mmol) Hexachlorethan wurden zu einer Suspension von 4 g (20 mmol) Methyldiphenylphosphin in 25 ml Azetonnitril unter Argonatmosphäre gegeben. Die Mischung wurde für 2.5 Stunden bei 95°C gerührt. Nach dem Abkühlen auf Raumtemperatur wurde eine Lösung von 0.98 g (9.1 mmol) Para-phenylendiamin und 6.3 ml (45.5 mmol) 2,3,4,6,7,8,9,10-Octahydropyrimidon[1,2-a]azepin in 10 ml Azetonnitril hinzugefügt. Die Mischung wurde für 16 Stunden bei 95°C gerührt und anschließend auf Raumtemperatur abgekühlt. Der Niderschlag wurde filtriert, getrocknet und in 2 molarer Natriumhydroxidlösung suspendiert und für 5 Minuten bei 45°C gerührt. 1.2 g (2.4 mmol; 26 %) einer braunen festen Substanz wurde nach dem Filtrieren, Waschen mit Wasser und Trocknen in Vakuum erhalten. Zur Charakterisierung wurde die Substanz mittels Gradientensublimation gereinigt.
Schmelzpunkt: 225°C
CV (DCM): -0.23 V vs. Fc

Die Dotierungsstärke wurde mittels Leitfähigkeitsmessungen bestimmt. Die Leitfähigkeit einer Dünnschichtprobe kann mit der sogenannten Zwei-Punkt-Methode gemessen werden. Hierbei werden auf ein Substrat Kontakte aus einem leitfähigen Material aufgebracht, beispielsweise Gold oder Indium-Zinn-Oxid. Danach wird die zu untersuchende Dünnschicht großflächig auf das Substrat aufgebracht, so dass die Kontakte von der dünnen Schicht überdeckt werden. Der Aufbau entspricht dem eines Widerstandes. Nach Anlegen einer Spannung an die Kontakte wird der hierdurch fließende Strom gemessen. Aus der Geometrie der Kontakte und der Schichtdicke der aufgebrachten Dünnschicht kann der Widerstand bzw. die Leitfähigkeit des Dünnschichtmaterials ermittelt werden.

Mehrere OTFTs wurden auf SiO2 Substraten hergestellt. Zur Herstellung eines OTFTs wurden auf dem Substrat eine Al Gate-Elektrode und ein Gate-Dielektrikum angeordnet. Das Gate-Dielektrikum kann beispielsweise aus 3.6 nm Aluminiumoxid und 1.7 nm Tetradecylphosphoniumsäure bestehen (Zschieschang, Adv. Mater, v.22 pp. 982 (2010)). Hierauf wurde eine Schicht aus F16CuPc mit einer Dicke von 30 nm als Halbleiterschicht angeordnet. Source- und Drain-Injektionsschichten wurden auf die Halbleiterschicht abgeschieden. Mit derselben Maske wurden anschließend eine Source- und eine Drain-Elektrode aus Gold aufgebracht, so dass eine n-dotierte Kanalschicht mit einer Breite von mehr als 1 µm gebildet wurde.

Die mehreren OTFTs wurden mit verschiedenen Kanalschichtbreiten hergestellt, so dass der Kontaktwiderstand durch Extrapolation bestimmt werden kann. Der Kontaktwiderstand beträgt 9 kOhm·cm für Injektionsschichten mit einer Dicke von 2.5 nm und 17 kOhm·cm für Injektionsschichten mit einer Dicke von 5 nm. Ein Vergleichsbeispiel ohne Dotierung hatte einen Kontaktwiderstand von 48 kOhm·cm auf.

Es wurde überraschend herausgefunden, dass nicht nur das Dotandenmaterial, sondern auch die hiermit hergestellten Bauelemente in Luft stabil sind. Nach 50 Tagen an normaler Atmosphäre, also der Luft und dem Umgebungssauerstoff ausgesetzt, hatte sich der Kontaktwiderstand auf 22 kOhm·cm erhöht. Das ist eine geringe Erhöhung im Vergleich zu dem undotierten Bauelement. Ein Vergleichsbeispiel mit einen anderen, stärkeren n-Dotanden hatte einen Anfangs-Kontaktwiderstand von 7 kOhm·cm gezeigt. Nach 50 Tagen unter normaler Atmosphäre betrug der Kontaktwiderstand jedoch schon 30 kOhm·cm.

Die in der vorstehenden Beschreibung, den Ansprüchen und der Zeichnung offenbarten Merkmale der Erfindung können sowohl einzeln als auch in beliebiger Kombination für die Verwirklichung der Erfindung in ihren verschiedenen Ausführungsformen von Bedeutung sein.

## Patentansprüche

1. Organisches elektronisches Bauelement, mit
- einer ersten Elektrode (11),
- einer zweiten Elektrode (12), und
- einer Kanalschicht (14), die ein organisches halbleitendes Material umfasst, **dadurch gekennzeichnet dass** das Bauelement
- ein Dotandenmaterial nach der Formel A-B aufweist,
wobei 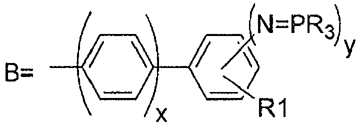 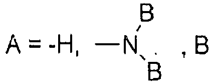 und wobei R1, R, x und y unabhängig für jedes B aus den folgenden Gruppen ausgewählt sind:
- x ist 0, 1 oder 2,
- y ist 1, 2, 3 oder 4,
- R ist aus der Arylgruppe und
- R1 ist aus Alkylgruppe oder der Alkoxygruppe.

2. Organisches elektronisches Bauelement nach Anspruch 1, **dadurch gekennzeichnet, dass** das Dotandenmaterial in einer Dotierungsmaterialschicht eingelagert ist.

3. Organisches elektronisches Bauelement nach Anspruch 2, **dadurch gekennzeichnet, dass** die Dotierungsmaterialschicht aus dem Dotandenmaterial besteht.

4. Organisches elektronisches Bauelement nach Anspruch 2 oder 3, **dadurch gekennzeichnet, dass** die Dotierungsmaterialschicht auf dem organischen halbleitenden Material angeordnet ist.

5. Organisches elektronisches Bauelement nach mindestens einem der vorangehenden Ansprüche, **dadurch gekennzeichnet, dass** das Dotandenmaterial in dem organischen halbleitenden Material eingelagert ist.

6. Organisches elektronisches Bauelement nach mindestens einem der vorangehenden Ansprüche, **dadurch gekennzeichnet, dass** der Betrag der Differenz zwischen dem Oxidationspotenzial des Dotandenmaterials und dem Reduktionspotenzial des organischen halbleitenden Materials größer als etwa 0,5 V ist.

7. Organisches elektronisches Bauelement nach mindestens einem der Ansprüche 2 bis 5, **dadurch gekennzeichnet, dass** die Dotierungsmaterialschicht mehrschichtig gebildet ist und eine erste Teilschicht und eine zweite Teilschicht umfasst, wobei die erste Teilschicht aus dem Dotandenmaterial besteht, die zweite Teilschicht aus einem Ladungsträger transportierenden Matrixmaterial besteht und die zweite Teilschicht zwischen der ersten Teilschicht und der Kanalschicht sowie in Kontakt mit der ersten Teilschicht und der Kanalschicht angeordnet ist.

8. Organisches elektronisches Bauelement nach mindestens einem der vorangehenden Ansprüche, dadurch **gekennzeichne**t, dass das organische halbleitende Material ein Elektronen leitendes Material ist.

9. Organisches elektronisches Bauelement nach mindestens einem der Ansprüche 2 bis 8, **dadurch gekennzeichnet, dass** die Dotierungsmaterialschicht in direktem Kontakt mit der ersten Elektrode und der zweiten Elektrode gebildet ist.

10. Organisches elektronisches Bauelement nach mindestens einem der vorangehenden Ansprüche, **dadurch gekennzeichnet, dass**
- die erste Elektrode als eine Drain-Elektrode konfiguriert ist,
- die zweite Elektrode als eine Source-Elektrode konfiguriert ist,
- eine Gate-Elektrode gebildet ist, und
- eine dielektrische Schicht zwischen der Kanalschicht und der Gate-Elektrode gebildet ist.

## Claims

1. An organic electronic component comprising:
- a first electrode (11),
- a second electrode (12), and
- a channel layer (14) comprising an organic semiconducting material, and
- a dopant material according to formula A-B,
wherein 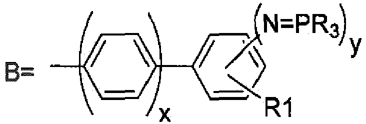 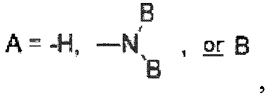 and
wherein R1, R, x, and y are independently selected from the following groups:
- x is 0, 1, or 2;
- y is 1,2, 3, or 4;
- R is an aryl group; and
- R1 is a hydrogen, an alkyl group, or an alkoxy group.

2. The organic electronic component according to Claim 1, **characterized in that** the dopant material is incorporated into a doping material layer.

3. The organic electronic component according to Claim 2, **characterized in that** the doping material layer consists of the dopant material.

4. The organic electronic component according to Claim 2 or 3, **characterized in that** the doping material layer is arranged on the organic semiconducting material.

5. The organic electronic component according to any of the preceding claims, **characterized in that** the dopant material is incorporated into the organic semiconducting material.

6. The organic electronic component according to any of the preceding claims, **characterized in that** the absolute amount of the difference between the oxidation potential of the dopant material and the reduction potential of the organic semiconducting material is greater than about 0.5 V.

7. The organic electronic component according to any of the claims 2 to 5, **characterized in that** the doping material layer comprises multiple layers, including a first partial layer and a second partial layer, wherein the first partial layer consists of the dopant material, the second partial layer consists of a charge carrier-transporting matrix material, and the second partial layer is arranged between the first partial layer and the channel layer and is in contact with the first partial layer and the channel layer.

8. The organic electronic component according to any of the preceding claims, **characterized in that** the organic semiconducting material is an electron-conducting material.

9. The organic electronic component according to any of the Claims 2 to 8, **characterized in that** the doping material layer is in direct contact with the first electrode and the second electrode.

10. The organic electronic component according to any of the preceding claims, **characterized in that**
- the first electrode is configured as a drain electrode,
- the second electrode is configured as a source electrode,
- the gate electrode is formed; and
- a dielectric layer is arranged between the channel layer and the gate electrode.

## Revendications

1. Composant électronique organique, comprenant
- une première électrode (11),
- une deuxième électrode (12), et
- une couche de canal (14), qui contient une matière organique semi-conductrice, **caractérisé en ce que** le composant
- comporte un matériau dopant selon la formule A-B,
dans laquelle 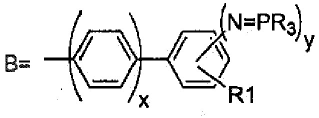 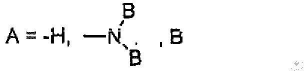 et dans laquelle R1, R, x et y, indépendamment pour chaque B sont choisis dans les groupes suivants :
- x est 0, 1 ou 2,
- y est 1, 2, 3 ou 4,
- R est du groupe aryle et
- R1 est du groupe alkyle ou du groupe alcoxy.

2. Composant électronique organique selon la revendication 1, **caractérisé en ce que** le matériau dopant est loge dans une couche de matériau dopant.

3. Composant électronique organique selon la revendication 2, **caractérisé en ce que** la couche de matériau dopant est constituée du matériau dopant.

4. Composant électronique organique selon la revendication 2 ou 3, **caractérisé en ce que** la couche de matériau dopant est placée sur la matière organique semi-conductrice.

5. Composant électronique organique selon au moins l'une quelconque des revendications précédentes, **caractérisé en ce que** le matériau dopant est logé dans la matière organique semi-conductrice.

6. Composant électronique organique selon au moins l'une quelconque des revendications précédentes, **caractérisé en ce que** le montant de la différence entre le potentiel d'oxydation du matériau dopant et le potentiel de réduction de la matière organique semi-conductrice est supérieur à environ 0,5 V.

7. Composant électronique organique selon au moins l'une quelconque des revendications 2 à 5, **caractérisé en ce que** la couche de matériau dopant est formée en plusieurs couches et comprend une première couche partielle et une deuxième couche partielle, la première couche partielle étant constituée du matériau dopant, la deuxième couche partielle étant constituée d'une matière matricielle transportant des porteurs de charge et la deuxième couche partielle étant placée entre la première couche partielle et la couche de canal, ainsi qu'en contact avec la première couche partielle et la couche de canal.

8. Composant électronique organique selon au moins l'une quelconque des revendications précédentes, **caractérisé en ce que** la matière organique semi-conductrice est une matière conductrice d'électrons.

9. Composant électronique organique selon au moins l'une quelconque des revendications 2 à 8, **caractérisé en ce que** la couche de matière dopante est formée en contact direct avec la première électrode et la deuxième électrode.

10. Composant électronique organique selon au moins l'une quelconque des revendications précédentes, **caractérisé en ce que**
- la première électrode est configurée comme une électrode de drain,
- la deuxième électrode est configurée comme une électrode de source,
- il est formé une électrode de grille, et
- il est formé une couche diélectrique entre la couche de canal et l'électrode de grille.
